# EUROPÄISCHE PATENTSCHRIFT

(11) **EP 0 963 464 B1**
(45) Veröffentlichungstag und Bekanntmachung des Hinweises auf die Patenterteilung: **18.07.2001**
(21) Anmeldenummer: 98904116.5
(22) Anmeldetag: 22.01.1998
(51) Int. Cl.: C30B 15/10, C30B 11/00, C30B 35/00

(54) **MIT SILICIUMSCHUTZSCHICHTEN VERSEHENE SCHMELZTIEGEL, EIN VERFAHREN ZUM AUFBRINGEN DER SILICIUMSCHUTZSCHICHT UND DEREN VERWENDUNG**
MELTING POT WITH SILICON PROTECTIVE LAYERS, METHOD FOR APPLYING SAID LAYER AND THE USE THEREOF
CREUSET MUNI DE COUCHES DE PROTECTION EN SILICIUM, PROCEDE D'APPLICATION LA COUCHE DE PROTECTION EN SILICIUM ET UTILISATION

(30) Priorität: 06.02.1997 DE 19704371
(43) Veröffentlichungstag der Anmeldung: 15.12.1999
(73) Patentinhaber: Deutsche Solar GmbH, 09599 Freiberg (DE)
(72) Erfinder: LANGE, Horst, D-44879 Bochum (DE); KRUMBE, Wolfgang, D-42799 Leichlingen (DE); GATZWEILER, Heinz, D-50668 Köln (DE)
(74) Vertreter: Rau, Manfred, Dr. Dipl.-Ing.
(86) Internationale Anmeldenummer: EP9800333
(87) Internationale Veröffentlichungsnummer: WO9835075

(56) Entgegenhaltungen:
- EP-A- 0 065 122
- REVEL G ET AL: "SELECTION OF A CRUCIBLE MATERIAL IN CONTACT WITH MOLTEN SILICON" 17.Oktober 1983 , PROCEEDINGS OF THE INTERNATIONAL PHOTOVOLTAIC SOLAR ENERGY CONFERENCE, KAVOURI, GREECE, 17 - 21 OCTOBER, 1983, NR. CONF. 5, PAGE(S) 1037 - 1042 , PALZ W;FITTIPALDI F XP000012948 siehe das ganze Dokument

## Beschreibung

Die Erfindung betrifft mit Siliciumschutzschichten versehene Schmelztiegel, ein Verfahren zum Aufbringen der Siliciumschutzschicht und deren Verwendung.

Auf dem Wege der Verarbeitung von hochreinem Silicium für Anwendungen in der Halbleitertechnik und der Photovoltaik spielt der Umgang mit Siliciumschmelzen eine zentrale Rolle. So werden aus den Siliciumschmelzen durch Czochralski-Verfahren Einkristalle für die Halbleitertechnik und die Photovoltaik gezogen. Ferner können Siliciumschmelzen durch Kristallisation nach dem Bridgman-Verfahren oder durch Blockguß mit nachfolgender gerichteter Kristallisation in ökonomisch günstiger Weise zu Blockmaterial mit vorteilhafter multikristalliner Gefügestruktur verarbeitet werden, das anschließend zu Siliciumwafern für die Herstellung multikristalliner Solarzellen aufgesägt wird. Siliciumschmelzen spielen ebenfalls eine wichtige Rolle bei verschiedenen metallurgischen Verfahren, die zur Reinigung des Siliciums eingesetzt werden, wie z.B. Verblasen mit unterschiedlichen reaktiven Gasen oder Schlackenextraktionsverfahren.

Bei diesen Prozessen ist der Einsatz von Materialien, die dem Angriff der korrosiven, heißen Siliciumschmelze widerstehen und gleichzeitig keine nicht tolerierbaren Verunreinigungen an die Reinstschmelze oder die noch zu reinigende Schmelze abgeben, von zentraler Bedeutung.

Üblicherweise werden zur Handhabung von Reinstsiliciumschmelzen Quarzglas- oder Quarzgutgeräte eingesetzt. Verschiedentlich werden aber auch Keramikformteile aus Siliciumnitrid oder siliciumnitridhaltige Keramik vorgeschlagen.

Beim Kontakt zwischen Quarz und flüssigem Silicium kommt es jedoch zu einer chemischen Reaktion unter Bildung von gasförmigem SiO. Durch diesen korrosiven Angriff wird nicht nur allmählich das von der Schmelze benetzte Material aufgelöst und somit bei langen Kontaktzeiten zerstört, sondern es kommt auch bei Kristallisation der Schmelze oder von Schmelzerückständen in Tiegeln oder Kokillen zu großflächigen Verklebungen und Verbackungen zwischen Formteil und festem Silicium. Aufgrund der unterschiedlichen thermischen Ausdehnungskoeffizienten von Quarz und Silicium treten thermische Spannungen auf, die regelmäßig zu Rissen, Sprüngen oder Abplatzungen während der Abkühlung des kristallisierten Siliciums führen. Bei Siliciumblöcken aus gerichteter Kristallisation, die zur Wiederverwendung in der Photovoltaik vorgesehen sind, führt dieses Phänomen zu erheblichen Materialverlusten. Im Extremfall können die thermomechanischen Spannungen so groß werden, daß durch Risse, Sprünge oder Abplatzungen sowie fest verbackene Quarzreste an den Blockwänden der gesamte Siliciumblock unbrauchbar wird.

Auch bei Kontakt von Siliciumschmelzen mit Formteilen aus Siliciumnitrid- oder siliciumnitridhaltiger Keramik kommt es zur Ausbildung fester Verbackungen zwischen kristallisiertem Silicium und Keramikformteil.

Verbackungen führen nicht nur zu erheblichen Einbußen bei der Ausbeute an verwertbarem Silicium, sondern verhindern auch die Wiederverwendung der Schmelztiegel. Darüber hinaus erfordern angebackene kristallisierte Siliciumblöcke einen erheblichen Aufwand, um überhaupt zu verwertbarem Material zu gelangen. Die zuverlässige Verhinderung von derartigen Verbackungen ist daher ein wichtiger Beitrag für eine ökonomische Produktion von Fertigteilen aus kristallinem Silicium.

EP-A-0 065 122 offenbart Geräte aus Siliciumnitrid, die bei der Herstellung von Silicium-Einkristallen aus einer Siliciumschmelze eingesetzt werden können, wobei zumindest ein Teil des Geräts, der mit dem geschmolzenen Silicium in Berührung kommt, aus einer Siliciumnitridschicht besteht, die durch Gasphasenabscheidung (CVD-Prozess) erzeugt wird. Die Geräte umfassen unter anderem Schmelztiegel, die ganz aus dem über den CVD-Prozess gewonnenen Siliciumnitrid bestehen oder aus einem Basismaterial, auf das das Siliciumnitrid abgeschieden wurde.

Zur Vermeidung eines Kontaktes der Siliciumschmelze mit dem Quarzformteil wurde in Conf Rec. of 15th Photovolt. Spec. Conference 1981, S. 576ff. sowie Solar Energy Materials 9, 337-345 (1983) eine Beschichtung der Quarzteile mit Siliciumnitridpulver vorgeschlagen, das eine nadel- bzw. whiskerartige Partikelmorphologie zeigt.

Es zeigte sich allerdings, daß eine derartige Beschichtung das Verkleben zwischen Quarz- oder Keramikbauteilen und Silicium mit den beschriebenen negativen Folgeerscheinungen vor allem bei der Handhabung größerer Schmelzemengen mit längeren Kontaktzeiten zwischen Schmelze und Formteil nicht zuverlässig über die gesamte Kontaktfläche zwischen flüssigem Silicium und Formteil verhindern kann. Hinzu kommen toxikologische Probleme, die eine arbeitshygienisch unbedenkliche Verarbeitung der Siliciumnitridwhisker nur mit erhöhtem sicherheitstechnischem und damit kostentreibendem Aufwand zulassen.

Weiterhin wurde in J. Crystal Growth 94 (1989) pp. 62 vorgeschlagen, den Kontakt zwischen Siliciumschmelze bzw. kristallisierendem Silicium und Schmelztiegel durch Aufbau eines Erdalkalihalogenid-Schmelzefilms zwischen Silicium und Tiegel zu verhindern und auf diese Weise Anbackungen zu vermeiden. Nachteilig bei dieser Verfahrensweise ist jedoch die Korrosion vor allem von Quarztiegeln durch die Erdalkalihalogenidschmelze bei längeren Kontaktzeiten von Siliciumschmelze und Schmelztiegel, wie sie bei der Kristallisation von großformatigen Blöcken mit Blockgerichten von mehr als 20 kg technisch unabdingbar sind. Hinzu kommt der unvermeidliche Verunreinigungseintrag von Erdalkalimetall in das hochreine Silicium. Ferner muß zwangsläufig hochreines, teures Erdalkalihalogenid verwendet werden, um eine unerwünschte Kontamination des Siliciums mit Verunreinigungen aus dem Erdalkalihalogenid zu vermeiden. Schließlich ist der Gesamtprozeß sehr empfindlich von der Stabilität des Erdalkalimetallhalogenid-Schmelzefilms zwischen Silicium und Tiegelwand abhängig; bei Riß oder unzureichender Dicke des Schmelzefilms sind großflächige Anbackungen bis hin zur Tiegelzerstörung unvermeidbar.

Eine Möglichkeit zur Vermeidung dieser Nachteile wird in der US-A 5.43 1.869 bereitgestellt. Hier wird ein Graphittiegel zunächst mit einem Siliciumnitridpulver beschichtet und anschließend zwischen Siliciumnitridpulverbeschichtung und Siliciumschmelze zusätzlich ein Erdalkalihalogenid-Schmelzfilm aufgebaut. Diese Arbeitsweise ist jedoch mit einem unvorteilhaft höheren Arbeitsaufwand verbunden und kontaminiert ebenfalls die Siliciumschmelze in unerwünschter Weise mit Erdalkalimetall und gegebenenfalls mit weiteren Verunreinigungen aus dem verwendeten Erdalkalimetallhalogenidgemisch. Hinzu kommt der Umstand, daß eine Erdalkalimetallhalogenidschmelze Siliciumnitrid korrodiert (siehe Gmelin Handbook Si Suppl. Vol. B 5 d 2, S. 214), so daß bei längeren Kontaktzeiten zwischen der Erdalkalihalogenidschmelze und der Siliciumnitridbeschichtung - wie sie bei der Kristallisation großformatiger Siliciumblöcke zwangsläufig sind - die schützende Tiegelbeschichtung durchbrochen werden kann. Bei direktem Kontakt zwischen Erdalkalihalogenidschmelze und Quarztiegel läuft man zudem Gefahr, daß neben erheblicher Tiegelkorrosion der Quarztiegel noch vor Abschluß der Siliciumkristallisation entglast und auf diese Weise zerstört wird. Damit steigt das Risiko des Tiegelversagens mit unkontrolliertem Schmelzeaustritt, bei der die Schmelzanlage beschädigt werden kann, und das kristallisierte Silicium für die Weiterverarbeitung unbrauchbar wird. Schutzfilme aus Erdalkalihalogenidschmelzen mit Quarztiegeln erscheinen daher für die Handhabung von Siliciumschmelzen ungeeignet.

Bei Verwendung von Erdalkalihalogenidschmelzefilmen auf Graphittiegeln ist nachteilig, daß die Ausformung des kristallisierten Siliciumblockes nur oberhalb des Schmelzpunktes des verwendeten Erdalkalihalogenids möglich ist. Dies ist für die Herstellung großformatiger Siliciumblöcke jedoch eine umständliche, arbeitsintensive und störanfällige Vorgehensweise.

Damit stellte sich die Aufgabe, eine Beschichtung für in Kontakt mit zunächst flüssigem und später rekristallisierendem Silicium kommende Bauteile bereitzustellen, die das Verkleben oder Verbacken auch bei Handhabung größerer Schmelzemengen und Einwirkung von flüssigem Silicium auf größere Bauteilflächen über längere Kontaktzeiten hinweg zuverlässig verhindert. Die Beschichtung soll ferner einfach und ökonomisch aufzubauen sein und auf den für die Siliciummetallurgie relevanten Materialien Quarz, Keramik und Graphit gleichermaßen gut anwendbar sein.

Überraschenderweise wurde die Aufgabe durch mit Siliciumnitridschutzschichten versehenen Schmelztiegeln aus Quarz-, Graphit- oder Keramik gelöst, wobei die Schichten aus Siliciumnitridpulver mit Pulverpartikeln bestehen, die einen O₂-Gehalt von 0,3 bis maximal 5 Gew.-% aufweisen und deren Verhältnis von Länge zu Durchmesser (1/d) <10 beträgt. In einer besonders bevorzugten Ausführungsform haben sich überraschend Siliciumnitridpulverschichten als besonders zuverlässig erwiesen, wobei das verwendete Siliciumnitridpulver zusätzlich zu einem maximalen O₂-Gehalt von 5 Gew.-% einen niedrig limitierten Alkali-, Erdalkali, Fluorid-, Chlorid-, Gesamtkohlenstoffgehalt sowie einen niedrig limitierten Gehalt an Eisen-, Chrom-, Kobalt-, Nickel-, Wolfram- und Titan-haltigen Partikeln aufweist.

Unter den Begriff Schmelztiegel im Sinne der Erfindung fallen dabei auch Gußkokillen und Formen, die zur Herstellung von Siliciumschmelzen, -blöcken, -stäben sowie -wafern verwendet werden.

Gegenstand der Erfindung sind daher mit Siliciumnitridschutzschichten versehene Schmelztiegel aus Quarz-, Graphit- oder Keramik zur Vermeidung von Verklebungen zwischen Schmelztiegel und Nichteisenmetallen nach Kontakt des Schmelztiegels mit erstarrenden Nichteisenmetallschmelzen, bei denen die Schichten aus einem Siliciumnitridpulver aus Partikeln bestehen und die einen Sauerstoffgehalt von 0,3 bis maximal 5 Gew.-% aufweisen und deren Verhältnis von Länge zu Durchmesser <10 beträgt. Das Verhältnis von Länge zu Durchmesser wurde dabei mit dem Rasterelektronenmikroskop ermittelt.

Als Nichteisenmetallschmelzen sind dabei Si, Al, Ge und/oder Ti-Schmelzen bevorzugt, wobei diese entweder in einer Form oder als Legierung vorliegen. Siliciumschmelzen sind dabei besonders bevorzugt.

In einer bevorzugten Ausführungsform der Erfindung weisen die mit Siliciumnitridschutzschichten versehenen Schmelztiegel, bevorzugt Sauerstoffgehalte von 0,3 bis 2 %, ganz besonders bevorzugt 0,3 bis 1,5 %; einen Alkali- und Erdalkalimetallgehalt von jeweils maximal 1000 ppm, besonders bevorzugt 1 bis 100 ppm, einen Fluoridgehalt von maximal 2000 ppm, besonders bevorzugt 10 bis 1000 ppm, einen Chloridgehalt von maximal 2000 ppm, besonders bevorzugt 30 bis 1000 ppm, einen Gesamtkohlenstoffgehalt von maximal 2000 ppm, besonders bevorzugt 50 bis 1500 ppm und einen Eisen-, Chrom-, Kobalt-, Nickel-, Wolfram- und/oder Titangehalt von jeweils maximal 100 Partikeln/g Siliciumnitridpulver auf. Die Fremdpartikelzahl wird dabei mittels rasterelektronischer Bilder in Kombination mit einer Elementverteilungskurve ermittelt. Dabei werden insbesondere Partikel mit einer Größe von mehr als 0,05 µm erfaßt.

Die Partikel der Siliciumnitridschicht haben vorzugsweise eine globulare oder knollenartige Struktur.

Vorzugsweise beträgt die mittlere Partikelgröße der Siliciumnitridpartikel maximal 50 µm, besonders bevorzugt 0,6 bis 6 µm. In einer besonders bevorzugten Ausführungsform der Erfindung weist das Siliciumnitridpulver einen Sauerstoffgehalt von 0,3 bis 1,5 Gew.-%, eine mittlere Partikelgröße von 0,6 bis 6 µm, einen Fluorid- und Gesamtkohlenstoffgehalt von maximal 1000 ppm und einen Anteil von 2 bis 100 %, vorzugsweise 5 bis 100 % der kristallographischen β-Phase auf

In einer weiteren Ausführungsform der Erfindung ist das globulare oder knollenartige Siliciumnitridpulver amorph.

In diesem Fall sind die Gehalte an Fremdelementen vorzugsweise identisch mit den zuvor beschriebenen Gehalten für die kristallophaphische β-Phase.

Siliciumnitridpulver der oben beschriebenen Spezifikation sind käuflich bei der Firma H.C. Starck, Goslar, Deutschland, erhältlich oder kann nach den in der DE-A 3 536 933 beschriebenen Verfahren hergestellt werden.

Die Siliciumnitridschutzschicht auf Quarz, Graphit oder Keramik ist vorzugsweise 50 bis 5 000 µm dick.

Gegenstand der Erfindung ist zudem ein Verfahren zum Aufbringen von Siliciumnitridschutzschichten auf dem Schmelztiegel, wonach Siliciumnitridpulver in einem Lösungsmittel, vorzugsweise Wasser oder einem Gemisch aus Wasser und einem hydrophilen organischen Lösungsmittel, dispergiert und anschließend durch Streichen, Sprühen, Spritzen, Tauchen oder durch elektrostatischen Auftrag einer Suspension, eines Schlickers oder als Pulver auf das Substrat aufgetragen und anschließend getrocknet wird.

Zur Verbesserung der Adhäsion der aufgetragenen Schicht können dem Dispergiermedium Haftvermittler wie Organosilane, Kieselsäureester, Polyole, Polyvinylalkohole, Acrylate und ähnliche Verbindungen zugesetzt werden. Ebenso können der Dispersion Stellmittel wie Verflüssiger (z.B. Aminoalkohole) oder Verdicker (z.B. Cellulosederivate) zur Anpassung des Fließverhaltens an das gewählte Beschichtungsverfahren zugefügt werden.

Art und Weise des Aufbringens der Schicht sowie die gegebenenfalls anschließende Nachtrocknung müssen so geführt werden, daß eine homogene, gleichmäßig aufgebaute riß- und abplatzungsfreie Schicht entsteht. Die Trocknung kann bei Raumtemperatur erfolgen. Bevorzugt sind jedoch Temperaturen oberhalb von 100°C.

Nach Trocknung der Schicht kann gegebenenfalls noch eine thermische Behandlung zur Entfernung organischer Stellmittel erfolgen. Im allgemeinen reicht es dazu aus, das beschichtete Bauteil kurzzeitig an Luft auf 500 bis 1000°C, vorzugsweise 500 bis 700°C, zu erhitzen. Der Begriff kurzzeitig umfaßt dabei den Zeitraum von 2 min und 10 Stunden. Die so beschichteten Bauteile erlauben nach Kontakt mit flüssigem und anschließend erstarrendem Silicium eine zerstörungsfreie, problemlose Ablösung des kristallisierten Siliciums vom Bauteil.

Gegenstand der Erfindung ist zudem die Verwendung der mit Siliciumnitridschutzschichten versehenen Schmelztiegel zur Herstellung von Siliciumschmelzen zur Aufnahme von flüssigem Silicium und zur Kristallisation von flüssigem Silicium zu Siliciumblöcken, -stäben oder -knüppeln und Siliciumwafern oder Siliciumgranulat.

Die nachfolgenden Beispiele dienen der Erläuterung der Erfindung, ohne dabei limitierend zu wirken.

### Ausführungsbeispiele

### Beispiel 1

Aus einem Siliciumnitridpulver mit einem Sauerstoffgehalt von 1,3 %, einem Fluoridgehalt von 6 ppm, einem Chloridgehalt von 800 ppm, einem Gesamtkohlenstoffgehalt von 700 ppm sowie einem Eisenpartikelgehalt von 2 Partikeln/g Siliciumnitridpulver mit einem Gehalt an kristallographischer β-Phase von 10% wurde eine wäßrige Dispersion mit einem Feststoffgehalt von 30 % hergestellt. Nach Zusatz von 0,5 % Polyvinylalkohol wurde mit dieser Dispersion ein Quarztiegel durch Sprühen beschichtet. Nach Trocknung der Beschichtung bei 150°C und Ausbrennen der organischen Additive durch Erhitzen auf 900°C an Luft wurde der so beschichtete Tiegel mit 100 kg flüssigem Silicium beschickt. Nach 3-stündiger Kontaktzeit zwischen beschichtetem Tiegel und Siliciumschmelze wurde das Schmelzevolumen zur Kristallisation gebracht. Nach Abkühlen auf Raumtemperatur ließen sich die durch Kristallisation des Quarzglases entstandenen Tiegelscherben problemlos von den Wänden des blockartig kristallisierten Siliciums entfernen. Anbackungen oder Verklebungen zwischen Tiegel und Silicium wurden über die gesamte Kontaktzone Tiegel - Silicium nicht beobachtet. Das blockartig kristallisierte Silicium erstarrte rißfrei und konnte in vollem Umfang, z.B. für die Herstellung von Siliciumwafern für die Photovoltaik, verwendet werden.

### Beispiel 2 (Vergleich)

Aus einem Siliciumnitridpulver mit einem Sauerstoffgehalt von 6 %, einem Fluoridgehalt von 2500 ppm, einem Chloridgehalt von 3000 ppm, einem Gesamtkohlenstoffgehalt von 2700 ppm, einem Eisenpartikelgehalt von 150 Partikeln/g Siliciumnitridpulver und einem Gehalt an kristallographischer β-Phase von 80 % wurde - wie in Beispiel 1 beschrieben - eine wäßrige Dispersion hergestellt, mit der ein Quarztiegel beschichtet wurde. Nach Beschicken des Quarztiegels mit 100 kg flüssigem Silicium, dreistündiger Kontaktzeit zwischen Schmelze und beschichtetem Tiegel und anschließender Kristallisation des Schmelzevolumens wurden massive Verbackungen zwischen Tiegel und kristallisiertem Silicium beobachtet. Beim Entfernen der Tiegelreste vom Siliciumblock kam es zu ausgedehnten Ausbrüchen und Abplatzungen am Block und damit zu erheblichen Materialverlusten. Das blockartig kristallisierte Silicium war zudem von zahlreichen sichtbaren ausgedehnten Rissen und haarfeinen Mikrorissen durchzogen und kam für eine ökonomische Weiterverarbeitung (z.B. für die Herstellung von Siliciumwafern für die Photovoltaik) nicht in Frage.

### Beispiel 3

Es wurde verfahren wie in Beispiel 2 beschrieben; verwendet wurde ein Siliciumnitridpulver mit einem Sauerstoffgehalt von 0,8 %, einem nicht nachweisbaren Fluoridgehalt, einem Chloridgehalt von 110 ppm, einem Gesamtkohlenstoffgehalt von 100 ppm, einer mittleren Partikelgröße von 10 µm, einem nicht nachweisbaren Eisenpartikelgehalt und einem Gehalt an kristallographischer β-Phase von 98 %. Das blockartig kristallisierte Silicium ließ sich problemlos von den kristallisierten Quarzscherben des Tiegels befreien; Risse im kristallisierten Silicium traten ebenso wie Anbackungen von Tiegelscheiben nicht auf Das kristallisierte Silicium eignete sich vollständig zur Weiterverarbeitung (z.B. zur Herstellung von Siliciumwafern für die Photovoltaik).

### Beispiel 4

Verwendet wurde ein amorphes Siliciumnitridpulver mit einem Sauerstoffgehalt von 0,4, einem nicht nachweisbaren Fluoridgehalt, einem Chloridgehalt von 4000 ppm, einem Gesamtkohlenstoffgehalt von 300 ppm, einer mittleren Partikelgröße von 0,1 µm und einem nicht nachweisbaren Eisenpartikelgehalt zur Herstellung einer Dispersion mit 30 % Feststoffanteil in Glykoldimethylether. Der Dispersion wurden 0,5 % Polyvinylalkohol als Haftvermittler zugesetzt. Anschließend wurde verfahren wie in Beispiel 1 beschrieben. Das blockartig kristallisierte Silicium erstarrte rißfrei und konnte vollständig (z.B. zur Herstellung von Siliciumwafern für die Photovoltaik) verwendet werden; Anbackungen mit den kristallisierten Quarzscherben wurden nicht beobachtet. Die Scherben der Quarztiegel ließen sich leicht und problemlos vom kristallisierten Silicium ablösen.

## Patentansprüche

1. Mit Siliciumnitridschutzschichten versehene Schmelztiegel aus Quarz-, Graphit- oder Keramik zur Vermeidung von Verklebungen zwischen Schmelztiegel und Nichteisenmetallen nach Kontakt des Schmelztiegels mit erstarrenden Nichteisenmetallschmelzen, dadurch gekennzeichnet, daß die Schichten aus einem Siliciumnitridpulver bestehen, die einen Sauerstoffgehalt von 0,3 bis maximal 5 Gew.-% aufweisen und deren Verhältnis von Länge (1) zu Durchmesser (d) <10 beträgt.

2. Mit Siliciumnitridschutzschichten versehene Schmelztiegel nach Anspruch 1, dadurch gekennzeichnet, daß diese einen Alkali- und Erdalkalimetallgehalt von jeweils maximal 1000 ppm, einen Fluoridgehalt von maximal 2000 ppm, einen Chloridgehalt von maximal 2000 ppm, einen Gesamtkohlenstoffgehalt von maximal 2000 ppm und einen Eisen-, Chrom-, Kobalt-, Nickel-, Wolfram- und/oder Titangehalt von jeweils maximal 100 Partikeln/g Siliciumnitridpulver aufweisen.

3. Mit Siliciumnitridschutzschichten versehene Schmelztiegel nach einem der Ansprüche 1 oder 2, dadurch gekennzeichnet, daß die mittlere Partikelgröße des Siliciumnitridpulvers maximal 50 um beträgt.

4. Mit Siliciumnitridschutzschichten versehene Schmelztiegel nach einem oder mehreren der Ansprüche 1 bis 3, dadurch gekennzeichnet, daß das Siliciumnitridpulver zu 2 bis 100 % aus kristallographischer β-Phase besteht.

5. Mit Siliciumnitridschutzschichten versehene Schmelztiegel nach einem oder mehreren der Ansprüche 1 bis 3, dadurch gekennzeichnet, daß das Siliciumnitridpulver amorph ist.

6. Verfahren zum Aufbringen von Siliciumnitridschutzschichten nach einem oder mehreren der Ansprüche 1 bis 5 auf dem Schmelztiegel, dadurch gekennzeichnet, daß Siliciumnitridpulver in einem Lösungsmittel dispergiert und anschließend durch Streichen, Sprühen, Spritzen, Tauchen oder durch elektrostatischen Auftrag einer Suspension, eines Schlickers oder als Pulver auf das Substrat aufgetragen und anschließend getrocknet wird.

7. Verwendung der mit Siliciumnitridschutzschichten versehenen Schmelztiegel nach einem oder mehreren der Ansprüche 1 bis 5 zur Herstellung von Siliciumschmelzen zur Aufnahme von flüssigem Silicium und zur Kristallisation von flüssigem Silicium zu Siliciumblöcken, -stäben oder -knüppeln und Siliciumwafern oder Siliciumgranulat.

## Claims

1. Silicon-nitride-protective-layer-coated melting pots of quartz, graphite or ceramics equipped with for agglutinations between the melting pots and nonferrous metals to be avoided after contact of the melting pot with solidifying nonferrous metal melts, characterized in that the layers consist of a silicon nitride powder, which have an oxygen content of 0.3 to maximally 5 % by weight and the ratio of which that the length (1) bears to the diameter (d) is < 10.

2. Silicon-nitride-protective-layer-coated melting pots according to claim 1, characterized in that they have an alkali metal content and an alkaline earth metal content of in each case 1000 ppm at maximum, a fluoride content of maximally 2000 ppm, a chloride content of 2000 ppm at maximum, a total carbon content of 2000 ppm at maximum and an iron, chromium, cobalt, nickel, tungsten and/or titanium content of in each case 100 particles / g of silicon nitride powder.

3. Silicon-nitride-protective-layer-coated melting pots according to one of claims 1 or 2, characterized in that the mean particle size of the silicon nitride powder is maximally 50 µm.

4. Silicon-nitride-protective-layer-coated melting pots according to one or several of claims 1 to 3, characterized in that the silicon nitride powder consists by 2 to 100 % of crystallographic beta phase.

5. Silicon-nitride-protective-layer-coated melting pots according to one or several of claims 1 to 3, characterized in that the silicon nitride powder is amorphous.

6. A method of applying, on the melting pot, silicon nitride protective layers according to one or several of claims 1 to 5, characterized in that silicon nitride powder is dispersed in a solvent and then applied by brushing, spraying, dipping or by electrostatic coating of a suspension, slurry or as a powder on the substrate and then dried.

7. Use of the silicon-nitride-protective-layer-coated melting pots according to one or several of claims 1 to 5 for the production of silicon melts, for the reception of liquid silicon and for the crystallization of liquid silicon into silicon blocks, rods or billets and silicon wafers or silicon pellets.

## Revendications

1. Creusets en quartz, en graphite ou en céramique munis de couches de protection en nitrure de silicium destinées à éviter des collages entre le creuset et des métaux non ferreux après le contact du creuset avec des masses en fusion de métaux non ferreux en cours de solidification, caractérisés en ce que les couches sont constituées d'une poudre de nitrure de silicium, qui ont une teneur en oxygène qui est comprise entre 0,3 et 5 % en poids maximum, et dont le rapport longueur (1) diamètre (d) est < 10.

2. Creusets munis de couches de protection en nitrure de silicium selon la revendication 1, caractérisés en ce que les couches ont une teneur respective en métal alcalin et alcalinoterreux de 1 000 ppm maximum, une teneur en fluorure de 2 000 ppm maximum, une teneur en chlorure de 2 000 ppm maximum, une teneur en carbone total de 2 000 ppm maximum, et une teneur maximale respective en fer, chrome, cobalt, nickel, tungstène et/ou titane de 100 particules/g de poudre de nitrure de silicium.

3. Creusets munis de couches de protection en nitrure de silicium selon l'une des revendications 1 ou 2, caractérisés en ce que la taille moyenne des particules de la poudre de nitrure de silicium est de 50 µm maximum.

4. Creusets munis de couches de protection en nitrure de silicium selon l'une ou plusieurs des revendications 1 à 3, caractérisés en ce que la poudre de nitrure de silicium est constituée de 2 à 100 % de phase cristallographique β.

5. Creusets munis de couches de protection en nitrure de silicium selon l'une ou plusieurs des revendications 1 à 3, caractérisés en ce que la poudre de nitrure de silicium est amorphe.

6. Procédé destiné à l'application sur le creuset de couches de protection en nitrure de silicium selon l'une ou plusieurs des revendications 1 à 5, caractérisé en ce que la poudre de nitrure de silicium est dispersée dans un solvant, et est ensuite appliquée sur le substrat à la brosse, par aspersion, pulvérisation, immersion ou dépôt électrostatique d'une suspension, d'une barbotine ou sous la forme de poudre, et ensuite séchée.

7. Utilisation de creusets munis de couches de protection en nitrure de silicium selon l'une ou plusieurs des revendications 1 à 5 pour la fabrication de silicium en fusion, et ce pour la réception de silicium liquide et la cristallisation de silicium liquide en blocs, barres, billettes et tranches de silicium, ou en granulat de silicium.
